# EUROPEAN PATENT APPLICATION

(11) **EP 1 998 446 A1**
(43) Date of publication of application: **03.12.2008**
(21) Application number: 07290682.9
(22) Date of filing: 31.05.2007
(51) Int. Cl.: H03J 1/00

(54) **Remote control for devices with connectivity to a service delivery platform**

(71) Applicant: Alcatel Lucent, 75008 Paris (FR)
(72) Inventor: Broos, Rudi Constantinus Josephina, 2910 Essen (BE); Defloor, Michel, 3012 Leuven (BE)
(74) Representative: Plas, Axel Ivo Michel

(57) **Abstract**

The present invention relates to a remote control (107; 201; 301) for controlling at least one device (101, 102, 103; 302) with connectivity to a service delivery network (105, 106). The remote control (107; 201; 301) comprising one or more displays (202) for showing display items which are indicative for one or more control instructions and the remote control (107; 201; 301) is able to adapt the display items and/or the control instructions in real-time depending on a selected service (303).

## Description

### Field of the Invention

The present invention generally relates to devices for interacting with service delivery systems, e.g. a set-top box, a decoder, a TV tuner, a PC, ... and more in particular to remote controls for such devices.

### Background of the Invention

Conventional remote controls are well known, in particular in relation to controlling TV and audio appliances. A remote control for television sets or other media appliances typically comprises a set of standard buttons such as numbered buttons, buttons to control audio volume, brightness, contrast, buttons to toggle the power of the television set, etc. By pushing the button, the viewer determines the action to be taken. Additional interactive services such as teletext can be controlled using both standard buttons, for instance the numbered buttons to indicate a desired page number, and additional buttons, for instance buttons to switch between television mode and teletext mode or coloured buttons to quickly access particular pages. Other interactive services related to digital television such as video-on-demand, pausing live broadcasts, consulting a television guide, managing customer made content, etc. require even more buttons on a remote control to navigate menus and select actions, or a separate remote control to interact with such services or the devices through which such services are delivered. These interactive services generally provide an on-saeen display of selectable items to the user, which can be shown by intermediate devices such as a set-top box based on information built into the set-top box, for instance the basic design of a menu, and information obtained from the interactive service, for instance the available functions for that particular menu. However, this requires that the controlled device has a screen, the user is able to watch the screen and distinguish the available options, and the user is able to look at the remote control simultaneously to use the correct buttons for selecting an available option and activating the selection.

Conventional remote controls are thus rather limited in functionality by design. It is not possible to extend a remote control with new functionality that requires new buttons on the remote. A possible solution to this problem is the use of touch-screen remote controls which show a number of soft-keys on the touch-screen. These soft keys can be adapted to a particular appliance such as a television set or video recorder to only show the buttons relevant for that particular appliance. However, remote controls with touch-screens are generally more expensive than a regular remote control, more expensive to produce and can easily be damaged, for instance when dropped on a hard surface. The displayed buttons and functionality of such a touch-screen remote control is subject to the software running thereon. Thus, a software update is mandatory for a remote control to support any new applications or appliances that are controlled with the remote control. In addition, if an application or appliance changes, for instance by new features, additional software upgrades are required on the remote control. In conclusion, a remote control can either be of a fixed layout which cannot be extended to support new features but which is more robust or it can have a dynamic layout which is difficult to update to new features, more expensive and prone to damage.

An additional problem with the known remote controls is their complexity. A user has to be able to read the markings on each button and understand the function of each button which may be problematic for remote controls with large numbers of buttons. A person with limited eyesight may not be able to read the markings on buttons or may even be unable to distinguish the individual buttons. A complex layout of a remote control may also be hard to understand for a disabled person. Furthermore, a user may not have the ability to physically operate a remote control with a complex layout, small buttons or buttons that are placed dose to each other.

An alternative to a remote control is a personal computer input device such as a keyboard. Keyboards are designed as generic input devices and rely on the software of the personal computer to support their functionalities. For instance, an operating system provides a mapping of key presses on a keyboard into characters for the software on the computer and thus allows a user to enter text and numbers in a text editor or spreadsheet. A computer game can interpret entered characters as commands for moving characters or performing actions in the game. Media player software can interpret characters as commands to control the media playback, for instance play, pause or stop a media file. In addition, a keyboard with small displays embedded in the keys such as the Optimus keyboard of Art Lebedev Studios (http://www.artlebedey.com/everything/optimus/) can be used to indicate the function of a button in a particular application, rather than a static label printed on the button. Keyboards and especially a keyboard with built-in displays are very versatile as they can be used in a wide range of applications, but each application needs proper software support to recognize keyboard input, control the displays in the keyboard, etc. Devices such as television sets, video recorders, set-top boxes, etc. cannot provide the proper support for each type of keyboard and their various design forms.

In conclusion, the existing remote controls are rigid and generally aimed at a particular service such as audio, video, gaming, etc. The often complex design due to the large number of buttons further reduces the user friendliness of a known remote control.

It is an objective of the present invention to provide a remote control which can easily be extended to new services. It is another objective of the present invention to overcome the above drawbacks of the prior art, in summary to improve the user friendliness.

### Summary of the Invention

According to the present invention, the above described objectives are realized by a remote control for controlling at least one device with connectivity to a service delivery network, the remote control comprising one or more displays for showing display items indicative for one or more control instructions and means for real-time adapting the display items and/or the control instructions depending on a selected service.

Indeed, through the ability to adapt the display items and the related instructions in real-time to a selected service, the remote control according to the present invention offers only functions relevant to the currently selected service and refrains from offering irrelevant functions or displaying superfluous buttons, icons, etc. Further, the number of items shown on the display of the remote control according to the present invention can be kept limited which reduces the complexity of the remote control and improves the user friendliness thereof. The ability to adapt the display items and the related instructions in real-time to a selected service further enables the remote control to adapt to new services and display items and instructions for new services. For instance, if a user selects a video on demand service, the remote control can show an item that enables a user to buy a particular media piece, an item to scroll the media on demand catalogue, an item to go back to a previous menu, an item to access favourite media pieces, etc. If for example a user is not able to buy media pieces, the remote control may be able to disable or suppress visualization of a "buy" button which only allows access to free media pieces, or the browse buttons can be disabled if the entire catalogue fits onto a single screen. If the user switches from media on demand to broadcast TV mode, the remote control can remove the buy and browse items from the display and show conventional numbered items for traditional channel selection, along with items for additional services such as pausing live broadcasts or an item for televoting if a broadcasted show offers televoting during the show.

The display items are the individual items shown on the display which can be selected or activated by a user to trigger one or more instructions. These display items generally are a graphical representation of the instruction, for instance text such as numbers for traditional channel browsing on a television set or words indicating the instruction, icons such as a square to stop audio/video playback, a triangle to start audio/video playback or even pictures, animations, audiofragments or videofragments. Each display item is generally linked to at least one instruction, the instruction being a control instruction that is transmitted to a controlled device. For instance, a number can be transmitted to a set-top box to select a broadcast channel, a buy-comrnand can be transmitted to order a piece of media content from an on demand service, a picture of a person can be shown and be linked to an instruction starting an instant messaging session with that person, etc.

Optionally, the remote control according to the present invention may comprise means for real-time adapting the display items and/or the control instructions depending on a device used in delivery of the selected service.

Indeed, each service has specific instructions that it recognises, and these instructions can vary between services. In addition, a device can recognise additional instructions or rather have limited features which do not allow particular instructions on that device. For instance, a service delivery network operator may offer a service where users can order music and video-clips related to the music. If a user wants to access this service using a television set, the remote control can show an item to select both the video-dip and the audio track and an item to only select the audio track because a television set is capable of offering both audio and video playback. However, if a user wants to access the same service using an audio setup, the remote control can be limited to showing an item for selecting the audio track because the device is not capable of offering video playback. Alternatively, a particular television set may support picture-in-picture and a different television set may not offer this function. The remote control for the first television set can show items for selecting additional media in picture-in-picture modus, i.e. have an item to order a second media item from a media-on-demand service, whereas a remote control for the second television set may not offer this item.

In other words, the remote control can be adapted to a selected service in real-time and take into account the possible features of the device used in delivery of the service, Such device can be a television set used to access video-on-demarid services or broadcast television services, an audio setup used to access audio-on-demand services or broadcast radio, a personal computer used to access online services, play games, etc. It is not necessary that only one device is involved in the service delivery. For instance, a television set can be connected to a set-top box, the remote control may then be adapted to the television set, the set-top box or even both.

Optionally, the remote control according to the present invention may further comprise means for receiving metadata indicative for the selected service.

This way, the remote control can receive metadata from a source external to the remote control such as a device under control, e.g. a set-top box, a television set, audio equipment, a personal computer, etc. or from the service delivery network whereover the services are provided and use the metadata to adapt the display items or instructions in real-time. As a result, a newly created service can automatically be accessed with existing equipment because the remote control can receive the metadata related to the new service when a user selects that service, For instance, if a provider offers media-on-demand and broadcast television services, the user can access a menu on his remote control with display items for these two services to select either of those services. If the operator introduces a new service to request a program that has just ended, the operator can deliver an additional display item for the new service along with the display items for the media-on-demand service and the broadcast television service to the remote control of a user.

Further optionally, the metadata according to the present invention may comprise information related to the appearance of one or more of the display items and/or information descriptive for one or more of the control instructions.

Thus, the metadata itself may provide sufficient information to a remote control for displaying items on the display. The display items can be static, for instance a text label, a picture, an icon, etc. or dynamic such as animations or video. In addition, the display items can be updated continuously by the service by frequent transmission of metadata. For instance, if a user is using an instant messaging service, the display items can be a picture of a user's friends (a so-called avatar) which is rather static information. However, these display items can be updated, e.g. when a friend selects a new picture or when the status of a user changes if the status is indicated on the picture. The metadata also may describe the order or positioning of items on the display. This can be done by numbering the items in their preferred display order or by showing the items in the order they are received.

The metadata also may define the control instructions that are linked to the display items. These control instructions define the actions taken by the remote control when a user selects a particular item, for instance by giving audio feedback upon selection, highlighting the selected item, etc. and the control instructions transmitted by the remote control to the device or service.

One example can be a video playback service. If the user selects the video playback service, his remote control receives metadata describing the various functions offered by the service such as items for browsing and starting or stopping playback. For the item starting the playback the metadata can describe the item as an icon of a triangle which is shown to the user, that the item has to be highlighted when selected and the signal that has to be transmitted to the set-top box when a user presses the playback button..

Further optionally, in the remote control according to the present invention, the means for receiving metadata may be adapted to operate on a wireless communication technology.

Wired communication may be used to deliver metadata from a device to a remote control. However, this requires that a user plugs a cable in a device and the remote control, which restricts real-time adaptation to adaptation at times when the cable is connected. Such cable reduces the mobility of a remote control and may be a hazard to other persons passing by as they may trip over the cable which can cause a fall or damage to the device and/or remote control.

A wireless communication receiver in the remote control can receive metadata at all times, if it is within range of the device holding the corresponding wireless transmitter. As such, the device can deliver the metadata to the remote control whenever metadata is received, which in turn enables the remote control to adapt its display items and/or control actions in real-time to the metadata. In addition, wireless communication reduces hazards to other people due to the absence of a physical connection.

The wireless communication may be between the device under control and the remote control, or another device such as an intermediate device (e.g. a set-top box) or even a combination of both. For instance, the device under control may deliver metadata related to its features while intermediate devices deliver metadata related to accessible services. Wireless technologies are a more convenient way of having multiple transmitters for a single receiver, i.e. the remote control has to listen on a single frequency, channel or other wireless data carrier and all the transmitters can use that single frequency, channel or carrier to transmit their metadata.

Still optionally, according to the present invention the wireless communication technology may be one or more out of:
- WiFi technology;
- Bluetooth technology;
- Infrared technology; and
- Radio Frequency technology.

Infrared technology has limited bandwidth and is ideal for transmitting basic metadata such as a display item marked with a single letter, number or word or very basic icons. In addition, infrared technology requires a line of sight between the remote control and the device which transmits the metadata. As a result, infrared technology may introduce problems in adapting the display items in real time. Therefore, technologies such as WiFi as defined in IEEE 802.11 a/b/g, Bluetooth, WiMax, radio frequency communication technology, etc. which offer much more bandwidth may be more beneficial. These technologies can also transport more advanced icons, pictures, animations, video etc. which increases the possibilities of the display items. These technologies are also independent of line-of-sight issues, making them always available.

Bluetooth allows the pairing of devices, for instance a remote control and a set-top box. This may be an advantage in that the set-top box and remote control can be limited to accept metadata from know or paired devices. This in turn minimizes chances for abuse by a third party transmitting invalid or malicious metadata, for instance with control instructions to turn off a device linked to a display item showing a playback function. WiFi may also be used in a similar fashion, e.g. by limiting the devices and remote controls based on a unique hardware identifier such as a MAC-address. Both WiFi and/or Bluetooth are often integrated in mobile devices such as laptops or personal digital assistants (PDA). Therefore, they can be adapted to communicate with devices such as television sets or set-top box for receiving metadata and even transmitting the selected control instructions. As such, these technologies allow a wider range of devices to be used as remote controls than dedicated devices.

Obviously, any alternative existing wireless communication technology may be considered when implementing embodiments of the present invention. These wireless technologies may be standardized technologies or even propriety protocols defined by vendors of remote controls, devices or operators of service delivery networks.

The Invention further relates to a device for use in a service delivery network in cooperation with a remote control according to the present invention, the device comprises means for generating metadata indicative for a service provided by the service delivery network and the device comprises means for transmitting the metadata to the remote control.

This device can either be part of the service delivery network or controlled device itself, for instance a module integrated in an application server or in the controlled, device which is programmed to transmit particular metadata for a particular service, or a separate device in the service delivery platform which is aware of the available services and the metadata for these services. Alternatively, the metadata can be generated based on a service description, rather than being predetermined for each service. For instance, there can be a set of predefined control instructions and each service can have a list of applicable control instructions. The device can then use this list to generate metadata which covers all control instructions for a particular service. The device can transmit the metadata for a particular service such as the service requested by a user to the remote control of the user. The device can transmit the metadata directly to the remote control, for instance in case the device is part of the controlled device. Alternatively, the device transmits the metadata to the remote control through intermediary devices such as nodes in the service delivery platform, the access network connecting a user's premises to the service delivery platform, nodes within the user premises such as a modem or set-top box, etc.

### Brief Description of the Drawings

Fig. 1 illustrates an environment wherein an embodiment of the remote control according to the present invention is used ;
Fig. 2 is a block scheme of the hardware of an embodiment of the remote control according to the present invention;
Fig. 3 illustrates a use case for an embodiment of the remote control according to the present invention; and
Fig. 3a to 3c show examples of display items on a display of the embodiment of the remote control according to the present invention that is used in the case illustrated by Fig. 3.

### Detailed Description of Embodiment(s)

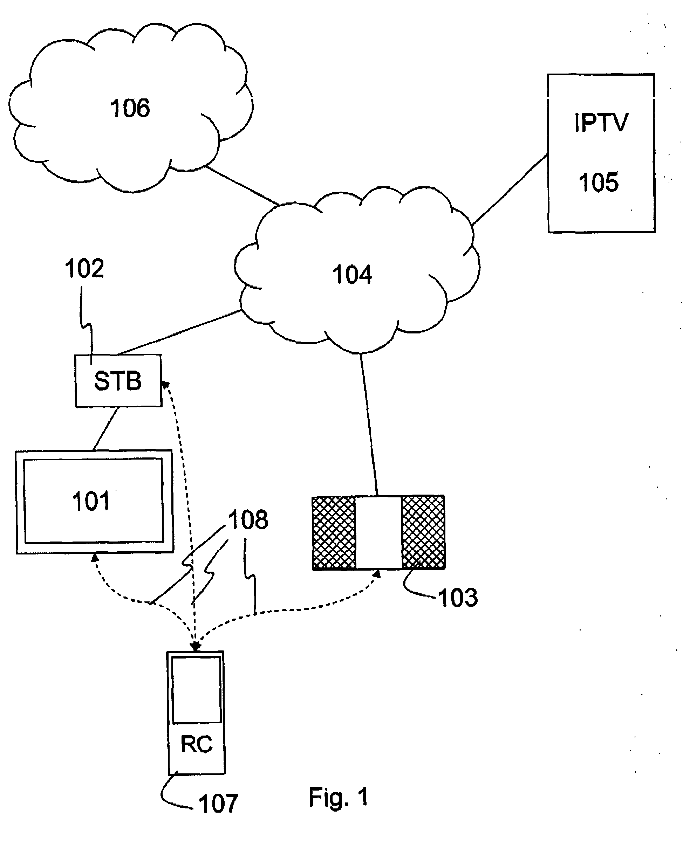

Figure 1 illustrates an environment with a television set 101 connected to a set-top box 102 and an audio appliance 103. The set-top box 102 is connected to an access network 104, for instance an Asymmetric Digital Subscriber Line (ADSL) network which provides access to Internet Protocol Television (IPTV) service (or middleware) 105 and the internet 106. The audio appliance 103 is also connected to the access network 104 and uses this access network 104 to communicate with music services located on the Internet 106.

Remote control 107 is used by a user to control the television set 101 for selecting channels, configuring the television set 101, switching the power off or on, etc. The remote control 107 can also be used to control set-top box 102, for instance to interact with IPTV service 105 or the Internet 106 and the remote control 107 can be used to control the audio appliance 103, for instance to change the volume, select a different song, etc. The remote control is connected with a wireless link 108 to each of these controlled devices, either simultaneously or independently. The links 108 can either be from remote control 107 to a device 101, 102 or 103, from a device 101, 102 or 103 to the remote control 107 or the links 108 can be bidirectional. In this particular embodiment, the link from the remote control 107 to the devices 101, 102 and 103 is based on infrared technology and all the devices 101, 102 and 103 use Bluetooth technology for the link to the remote control 107.

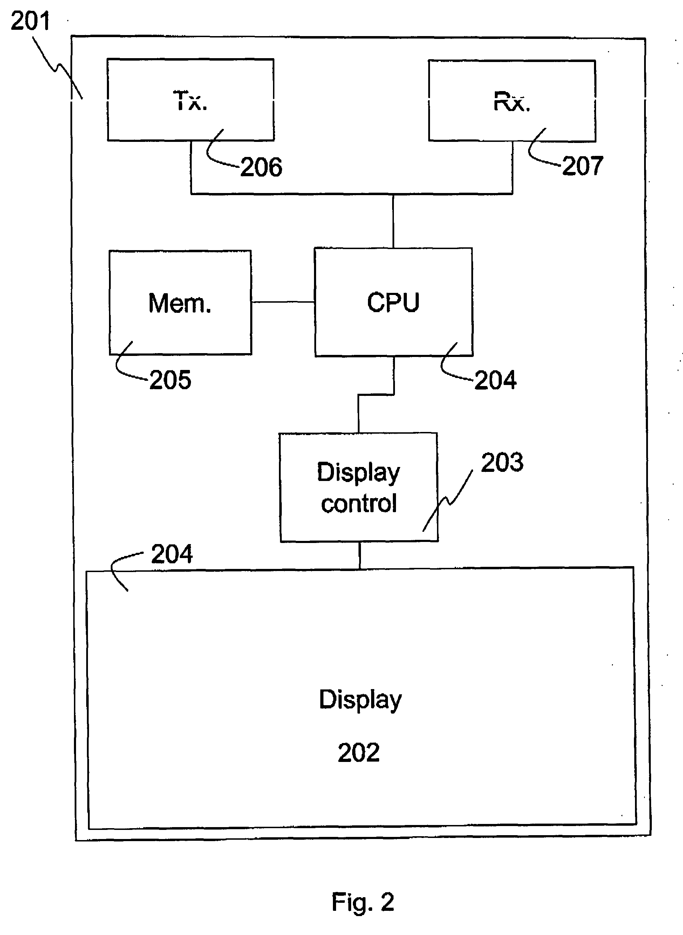

Fig. 2 illustrates a hardware overview of a possible embodiment of a remote control 201 according to the present invention. The remote control 201 contains a display 202, which in this particular embodiment is a colour-display, sensitive to touch which can be used to show information to a user and to receive input from the user. Alternatively, the display 202 can be made up out of multiple smaller displays which are placed next to each other or multiple displays which also act as physical buttons and provide tactile feedback to pushing the display. The items shown on the display 202 are controlled by display controller 203. The display controller 203 receives instructions from the central processing unit (CPU) 204 and translates these instructions into images on the display 202, for instance by setting the colour for each pixel on the display 202. The CPU 204 handles all actions inside the remote control 201. The CPU 204 can read information from memory 205 such as a basic layout of a menu on the display 202, functionality of particular devices such as channel selection and audio volume adjustment for television sets or audio appliances which may be built-in into the remote control 201. The CPU 204 can also instruct the transmitter 206 to send signals to a device. The transmitter 206 can either be the physical transmitter or a combination of a controller and the physical transmitter. The physical transmitter emits infrared signals, WiFi signals, Bluetooth signals, etc whereas the controller can generate these signals before they are emitted. The remote control also contains a receiver 207, which receives signals such as WiFi signals or Bluetooth signals and which can transmit these signals to the CPU 204. The CPU 204 can then interpret these signals, for instance the metadata transported in a WiFi signal that is received by receiver 207. in accordance with the metadata, the CPU 204 can send instructions to the display controller 203 which in turn will update the display 202.

When a user makes a selection on the display 202, e.g. by touching an item on the display 202, the controller 203 is informed of the selection, for instance by receiving coordinates which were touched from display 202. The display controller 203 can then pass this information to the CPU 204 which can determine the control instructions related to that item, for instance by performing a lookup operation in memory 205 or because the control instructions were given by display controller 203. The CPU 204 can then pass these control instructions to the transmitter 206 which emits a signal to the controlled device. Alternatively, the display 202 may be adapted to a fixed number of items and the CPU 204 receives the number of a selected item. It may then only need to transmit this number to the controlled device in order for the device to perform particular functions.

It should be noted that some elements that are shown as individual components in Fig. 2 may be integrated into a single component in an alternative embodiment. For instance, the memory module 205 may be part of the CPU 204 or the display controller 203 can be Integrated with display 202. The transmitter and receiver may also be a single hardware element, capable of sending and receiving signals over a particular medium or using a particular protocol. Some elements may also be realized in software, for instance the functionality of the memory and CPU may be software running on devices such as a PDA or mobile telephone which use the communication technologies embedded into the PDA or mobile telephone. In addition, the remote control may also contain additional elements, such as additional memory modules used by the display controller, additional transmitters or receivers, a connector for a wired connection, a slot for memory cards and a memory card reader, etc.

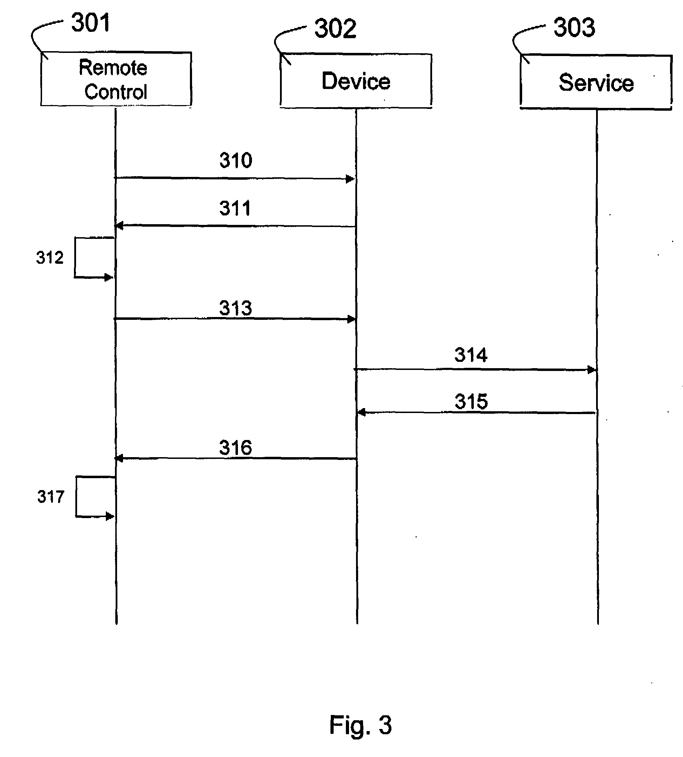

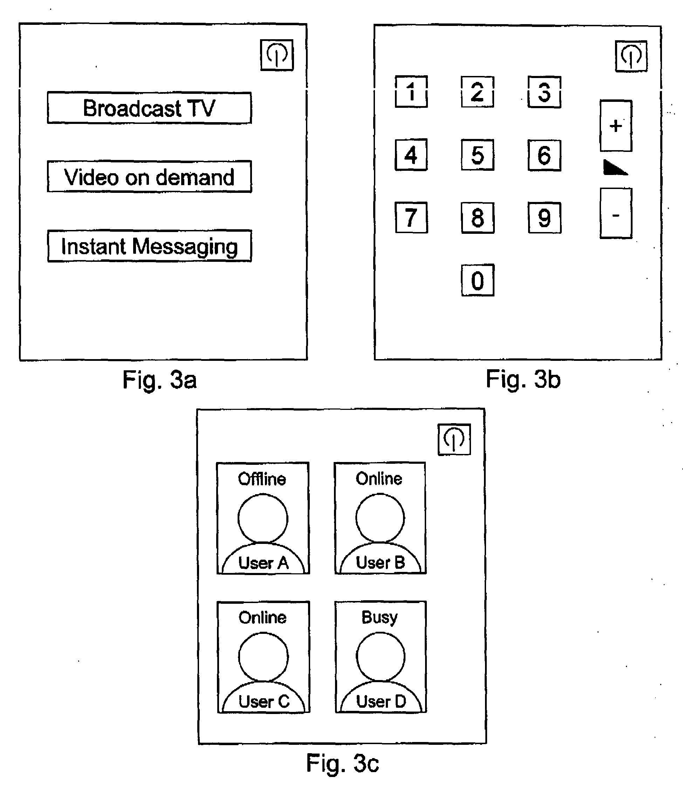

Fig. 3 illustrates a possible use case of an embodiment of the remote control 301 according to the present invention. The figure shows interaction between remote control 301, a device 302 and a service 303. In this particular example, the remote control 301 could correspond to the remote control 107 of Fig. 1, the device 302 could correspond to the set-top box 102 of Fig. 1 and the service 303 could be a service offered by IPTV service 105 of Fig.1.

A user takes his remote control 301 and selects a broadcast TV service from a list of available services such as shown in Fig. 3a. The remote control 301 will send an instruction to the device 302 to indicate that the user wants to use the broadcast TV service which is shown by arrow 310. The device 302 sends a reply 311 which contains metadata related to the broadcast TV service. This metadata contains for instance a description of 10 buttons, labelled 0 to 9, two buttons for audio adjustments and a button to switch the power on or off. The remote control 301 will use this description in step 312 to visualize the buttons on the display of the remote control 301. An example of the display after step 312 is shown in Fig. 3b.

The user then selects the Instant Message service (e.g. by returning to the previous menu of Fig. 3a and selecting the Instant Message service), the remote control 301 sends a request 313 for that service to device 302. The device 302 cannot provide the requested information. As it needs information from the service 303, it forwards the request in a message 314. The service 303 can then interpret the message 314, retrieve the appropriate information and send an answer 315 back to the device 302. Answer 315 contains metadata related to the Instant Message service, which in this particular example consists of a picture for each person on the user's contact list, a name for each contact and status information, for instance indicating if a contact is online, offline or busy. Obviously, other information can be displayed as well such as additional status information (e.g. indicating the contact is in a phonecall, will be right back, ...) or information such as upcoming appointments with the contact or a contacts birthday. The device 302 can then deliver the metadata to the remote control 301 in a response 316, which is then processed by the remote control 301. Step 317 indicates the processing of the response 316 and updating the display of remote control 301 with the received metadata. Fig. 3c shows an example of the display after step 317.

Fig. 3a to 3c each show an example of the display on a remote control at a given point in time during the above described use case. Generally, all the individual items can be selected by a user to trigger an action from a device or instruction. The user can select an item by touch if a touch-screen is used, by using arrow keys on the remote control to navigate over the available items and a button to make a selection, etc.

It should be noted that the there may be additional intermediate devices between the remote control and the service, for instance device 302 may be the television set which is connected to the service 303 through a set-top box. Such intermediate devices may alter the messages transmitted between various elements in the figure, may respond to particular parts of a request (e.g. a user may request a menu, the television set passes the request to the set-top box which can provide the basic layout of the menu but needs to request the details of the menu from the service) or may only pass the message on to a next node.

Additionally, the display layouts as shown in Fig. 3a - 3c are only examples of possible layouts. These should not be considered as the only possibilities. For instance, the menu as shown in Fig. 3a can be extended with additional options such as a service for audio on demand services, Internet access, e-mail services. The layout of Fig. 3b can be extended with additional buttons such as a button to go to the next and/or previous channel, a button to access features like teletext, switch devices, etc. The layout of Fig. 3c can be enhanced with animations instead of pictures or be adapted to a textual representation of the contact list. In addition, the images shown in Fig. 3c can be updated continuously to changing conditions such as contacts coming online or changing status from online to busy. In addition, the layout of Fig. 3c can be changed to show more or less contacts on the screen.

Although the present invention has been illustrated by reference to specific embodiments, it will be apparent to those skilled in the art that the invention is not limited to the details of the foregoing illustrative embodiments, and that the present invention may be embodied with various changes and modifications without departing from the spirit and scope thereof. The present embodiments are therefore to be considered in all respects as illustrative and not restrictive, the scope of the invention being Indicated by the appended claims rather than by the foregoing description, and all changes which come within the meaning and range of equivalency of the claims are therefore Intended to be embraced therein. In other words, it is contemplated to cover any and all modifications, variations or equivalents that fall within the spirit and scope of the basic underlying principles and whose essential attributes are claimed in this patent application. It will furthermore be understood by the reader of this patent application that the words "comprising" or "comprise" do not exclude other elements or steps, that the words "a" or "an" do not exclude a plurality, and that a single element, such as a computer system, a processor, or another integrated unit may fulfil the functions of several means recited in the claims. Any reference signs in the claims shall not be construed as limiting the respective claims concerned.

## Claims

1. A remote control (107; 201; 301) for controlling at least one device (101, 102, 103; 302) with connectivity to a service delivery network (105, 106), said remote control (107; 201; 301) comprising one or more displays (202) for showing display items indicative for one or more control instructions,
**characterized in that** said remote control (107; 201; 301) further comprises means (203, 204) for real-time adapting said display items and/or said control instructions depending on a selected service (303).

2. The remote control (107; 201; 301) according to claim 1, **characterized in that** said remote control (107; 201; 301) further comprises means (203, 204) for real-time adapting said display items and/or said control instructions depending on a device (101, 102, 103; 302) used in delivery of said selected service (303).

3. The remote control (107; 201; 301) according to claim 1, **characterized in that** said remote control (107; 201; 301) further comprises means (207) for receiving metadata indicative for said selected service (303).

4. The remote control (107; 201; 301) according to claim 3, **characterized in that** said metadata comprises information related to the appearance of one or more of said display items and/or information descriptive for one or more of said control instructions.

5. The remote control (107; 201; 301) according to claim 3, **characterized in that** said means (207) for receiving metadata are adapted to operate on a wireless communication technology.

6. The remote control (107; 201; 301) according to claim 5, **characterized in that** said wireless communication technology is one or more out of:
- WiFi technology;
- Bluetooth technology;
- infrared technology; and
- Radio Frequency technology.

7. A device for use in a service delivery network in cooperation with a remote control (107; 201; 301) according to claim 1,
**characterized in that** said device comprises means for generating metadata indicative for a service (303) provided by said service delivery network (105, 106) and said device comprises means for transmitting said metadata to said remote control (107; 201; 301).
